# FASCICULE DE BREVET EUROPEEN

(11) **EP 2 355 636 B1**
(45) Date de publication et mention de la délivrance du brevet: **05.06.2013**
(21) Numéro de dépôt: 11153447.5
(22) Date de dépôt: 04.02.2011
(51) Int. Cl.: H05K 7/14

(54) **Ensemble de connexion d'au moins un équipement électronique dans un aéronef**
Anschlusseinheit mindestens einer elektronischen Ausrüstung in einem Luftfahrzeug
Device for connecting at least one electronic device in an aircraft

(30) Priorité: 05.02.2010 FR 1050835
(43) Date de publication de la demande: 10.08.2011
(73) Titulaire: Airbus Operations, 31060 Toulouse (FR)
(72) Inventeur: Colongo, Emile, 31310, Montesquieu Volvestre (FR); Salles, Pierre, 31880, La Salvetat St Gilles (FR)
(74) Mandataire: Petit, Maxime

(56) Documents cités:
- EP-A1- 1 380 196
- EP-A1- 1 793 659
- WO-A2-2009/106430
- FR-A1- 2 927 222
- US-A- 5 381 314
- US-A1- 2003 036 347

## Description

La présente invention concerne un ensemble de connexion d'au moins un équipement électronique dans un aéronef.

Dans un aéronef, de nombreux équipements électroniques sont localisés dans une zone située sous le cockpit de l'aéronef, qui offre aux équipements des conditions environnementales privilégiées telles qu'une pression ambiante raisonnable et une température ambiante maîtrisée. Des moyens de support sont disposés dans cette zone et permettent de fixer les équipements, de les connecter au câblage de l'aéronef et de les ventiler.

Le document US2004050569 décrit et représente un ensemble de connexion connu, dans lequel au moins un équipement électronique est disposé dans un moyen de support. Ce moyen de support est rapporté sur une structure porteuse mobile. La structure porteuse comprend une interface de connexion sur laquelle vient se connecter le moyen de support. L'ensemble ainsi formé est amené dans la zone souhaitée, à côté d'autres ensembles formés séparément et le câblage de l'aéronef est rapporté sur chaque interface de connexion solidaire d'un moyen de support.

Le document EP 1 793 659 décrit une armoire électrique fixée à la structure de l'aéronef dans laquelle elle est embarquée, comportant un support de câblage.

Les équipements électroniques qu'elle contient sont connectés au câblage de l'aéronef par l'intermédiaire d'une interface fixée à l'armoire à travers un support métallique.

Le document US 2003/0036347 décrit un fond de compartiment de stockage pour modules dans un aéronef. Il contient un équipement électronique dont le fond de panier est solidaire d'un support métallique fixé à la structure de l'aéronef.

L'invention vise à proposer un ensemble de connexion d'un équipement électronique simplifié par rapport à l'art antérieur, notamment dans les opérations d'installation, de câblage, et de manutention ultérieure de l'ensemble électronique.

A cet effet, l'invention a pour objet un ensemble de connexion comprenant au moins un équipement électronique disposé dans un moyen de support, l'équipement électronique comportant des moyens de connexion adaptés à être raccordés à un câblage d'aéronef et une interface de connexion disposée entre le câblage de l'aéronef et les moyens de connexion pour assurer la connexion d'au moins un équipement électronique audit câblage,
ledit ensemble de connexion étant adapté à passer d'un état connecté dans lequel les moyens de connexion sont raccordés à l'interface de connexion à un état déconnecté dans lequel les moyens de connexion sont libres,
caractérisé en ce que :
- ladite interface de connexion est fixée à la structure de l'aéronef, que l'ensemble de connexion soit dans l'état connecté ou déconnecté,
- le moyen de support est mobile et comporte une face au moins partiellement ouverte orientée vers l'interface de connexion et sur laquelle débouchent les moyens de connexion, et
- la connexion dudit ensemble de connexion à l'interface de connexion se fait par déplacement du moyen de support entre une première position où l'ensemble de connexion est dans un état déconnecté et une deuxième position où il est dans un état connecté.

Un tel ensemble permet avantageusement de réduire l'encombrement du câblage de l'aéronef du fait de l'intégration de l'interface de connexion dans la structure de l'aéronef, et permet l'utilisation d'un moyen de support modulaire simplifié du fait que l'interface de connexion est rapportée directement sur l'aéronef. En outre, un pré-câblage est rendu possible entre l'interface de connexion et le câblage de l'aéronef ce qui offre une modularité et un gain de temps dans les opérations de montage d'un aéronef.

On notera que la face du moyen de support peut être totalement ou partiellement ouverte. En cas d'ouverture partielle, les moyens de connexion sont disposés en regard de la ou des ouvertures pour permettre le raccordement à l'interface de connexion en vis-à-vis.

Selon différentes caractéristiques :
- l'interface de connexion présente une première face orientée vers l'intérieur de l'aéronef, et une deuxième face orientée vers la structure de l'aéronef, le câblage étant rapporté sur ladite deuxième face de l'interface de connexion;
- les moyens de connexion dudit au moins un équipement électronique étant appelés premiers moyens de connexion, l'interface de connexion comporte des seconds moyens de connexion adaptés pour coopérer avec les premiers moyens de connexion dudit au moins un équipement électronique.

Selon une caractéristique, l'interface de connexion comporte au moins un panneau qui, d'une part, est relié au câblage de l'aéronef et, d'autre part, porte les seconds moyens de connexion qui sont aptes à coopérer avec les premiers moyens de connexion.

On notera que, de façon générale, les faisceaux de câble constituant le câblage de l'aéronef comportent à leurs extrémités des connecteurs qui sont montés sur la face arrière du panneau, tandis que la face avant porte les seconds moyens de connexion.

Selon une caractéristique, les seconds moyens de connexion sont montés au moins en partie sur un ou plusieurs circuits électroniques (ex : cartes électroniques) fixés au panneau.

Ainsi, le panneau peut comporter des seconds moyens de connexion montés intégralement sur un ou plusieurs circuits électroniques du panneau.

Une telle configuration est utile lorsqu'il est nécessaire d'adjoindre de l'intelligence en plus de la réalisation physique des connexions câblage de l'aéronef - équipement électronique.

L'ajout de fonctionnalités à l'établissement des connexions nécessite l'emploi de circuit(s) électronique(s).

Il peut par exemple être intéressant de contrôler et/ou gérer des fonctions exercées dans les équipements, de gérer la redondance dans la distribution d'énergie électrique aux équipements, d'intégrer des protections contre la foudre, de commuter des connexions entre le câblage et des équipements...

Alternativement, le panneau peut comporter des seconds moyens de connexions montés directement sur le panneau, sans avoir recours à des circuits électroniques.

Cette configuration peut s'avérer utile lorsque l'on souhaite simplifier l'interface et perturber le moins possible les signaux à transmettre.

Cette configuration est notamment intéressante en cas de signaux particulièrement simples ou relativement complexes.

Par ailleurs, le montage direct est préféré pour les connectiques plus complexes telles que celles liées à l'utilisation de fibres optiques, pour des raisons de facilité de gestion.

Selon une variante, le panneau peut comporter un ou plusieurs circuits électroniques portant une partie des seconds moyens de connexion, tandis que l'autre partie des seconds moyens est directement fixée sur le panneau.

Selon d'autres caractéristiques :
- l'interface de connexion comporte au moins un panneau fixe relié au câblage de l'aéronef et portant des seconds moyens de connexion aptes à coopérer avec les premiers moyens de connexion d'un premier équipement électronique, et au moins un panneau mobile portant des seconds moyens de connexion, ledit panneau étant mobile entre une première position située dans le plan de ladite interface et dans laquelle un deuxième équipement électronique est raccordé au câblage de l'aéronef par l'intermédiaire des seconds moyens de connexion portés par le panneau mobile, et une deuxième position escamotée dans laquelle le deuxième équipement électronique est raccordé directement au câblage de l'aéronef sans l'intermédiaire des seconds moyens de connexion portés par le panneau mobile ; le fait que le panneau est mobile permet d'accéder au câblage de l'aéronef (par exemple pour des opérations de maintenance) sans avoir à démonter l'interface de connexion ;
- le moyen de support mobile comporte au moins une face ouverte, ledit au moins un équipement électronique étant disposé dans le moyen de support de sorte que les premiers moyens de connexion portés par ledit au moins un équipement électronique débouchent sur cette face ouverte ;
- des moyens de guidage sont disposés sur la structure de l'aéronef, pour guider le moyen de support mobile lors de son déplacement entre une première et une deuxième position;
   - des moyens de guidage sont disposés sur la structure de l'aéronef, pour guider le moyen de support mobile lors de son déplacement entre une première et une deuxième position;
   - le moyen de support mobile intègre un système de refroidissement, autonome ou interconnecté avec le réseau de refroidissement de l'aéronef ;
   - le moyen de support mobile présente deux faces opposées ouvertes, de sorte que les premiers moyens de connexion d'un équipement électronique débouchent sur la première face, l'équipement électronique pouvant être inséré par la deuxième face ;
   - l'interface de connexion est directement fixée sur la structure, ou bien fixée sur la structure par l'intermédiaire d'un élément de rigidification ou d'isolation ;
   - le moyen de support mobile comporte au moins une étagère sur laquelle des équipements électroniques peuvent être intégrés, ledit moyen de support pouvant comporter plusieurs étagères disposées les unes au dessus des autres, et/ou à côté des autres.

L'invention porte également sur un procédé de connexion d'au moins un équipement électronique à un câblage d'un aéronef, dans lequel :
- on insère au moins un équipement électronique dans un moyen de support mobile, de sorte que des premiers moyens de connexion portés par l'équipement électronique débouchent sur une face au moins partiellement ouverte du moyen de support mobile ;
- on amène le moyen de support mobile au voisinage d'une interface de connexion fixée sur la structure de l'aéronef, la face au moins partiellement ouverte du moyen de support étant orientée vers l'interface de connexion ; et
- on connecte les premiers moyens de connexion à des seconds moyens de connexion portés par l'interface de connexion par déplacement du moyen de support entre une première position où l'ensemble de connexion est dans un état déconnecté et une deuxième position où il est dans un état connecté.

Selon une caractéristique, on peut réaliser dans des étapes préalables le raccordement de l'interface de connexion au câblage de l'aéronef et la fixation de l'interface de connexion sur la structure de l'aéronef.

L'invention porte également sur un aéronef comportant au moins un ensemble de connexion d'un équipement électronique selon l'invention tel que brièvement exposé ci-dessus.

Les caractéristiques et avantages de l'invention ressortiront de la description qui suit, donnée à titre d'exemple préféré, mais non limitatif, en référence aux dessins annexés, sur lesquels :
- la figure 1 est une représentation schématique d'un ensemble de connexion selon un premier mode de réalisation de l'invention, dans lequel le moyen de support est dans une première position dite de retrait ;
- la figure 2 est une représentation schématique de l'ensemble de connexion de la figure 1 dans lequel le moyen de support est dans une deuxième position dite active ;
- la figure 3 est une représentation schématique du moyen de support et des premiers moyens de connexion des équipements électroniques, vue de trois quart arrière ;
- la figure 4 est une représentation schématique équivalente aux figures 1 et 2, d'un ensemble de connexion selon un autre exemple de réalisation de l'invention, le moyen de support étant dans une première position dite de retrait, le panneau mobile étant dans une deuxième position dite escamotée ;
- la figure 5 est une représentation schématique d'une variante de réalisation de l'ensemble de la figure 4, le panneau mobile étant enlevé ;
- la figure 6 est une représentation schématique équivalente à la figure 1, d'un ensemble de connexion selon encore un autre exemple de réalisation de l'invention, le moyen de support étant dans une première position dite de retrait.

L'ensemble de connexion 1 d'un équipement électronique 2 comporte au moins un moyen de support mobile 4 et une interface de connexion 6. L'ensemble de connexion est disposé dans un aéronef, et assure le raccordement de l'équipement électronique 2 au câblage de l'aéronef.

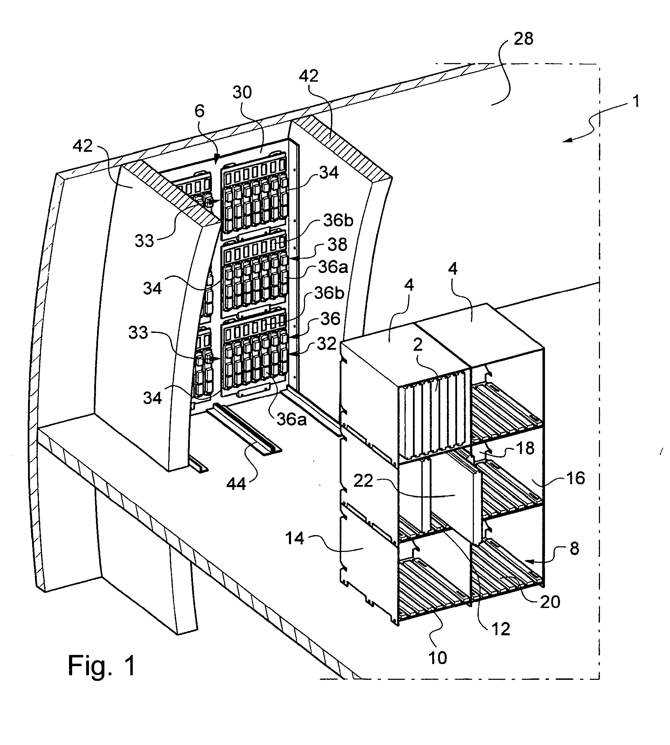

Le moyen de support mobile 4, illustré sur les figures 1 à 6, forme en quelque sorte un meuble qui comporte des modules 8 de section sensiblement rectangulaire. Chaque module 8 comporte une étagère inférieure 10 et une étagère supérieure 12, reliées par deux parois latérales 14, qui délimitent ainsi une face avant 16 et une face arrière 18. La face avant et la face arrière de chaque module sont par exemple ouvertes, sans parois.

Tel qu'illustré sur les figures, trois modules 8 sont ici empilés les uns sur les autres, pour former une hauteur déterminée du moyen de support 4. En outre, ici, deux colonnes de modules sont positionnées côte à côte. Les six modules 8 ont les mêmes dimensions et sont alignés, de sorte que chaque face arrière 18 est comprise dans un même plan vertical.

Des moyens formant glissière 20 sont aménagés sur les faces en vis-à-vis de l'étagère inférieure 10 et de l'étagère supérieure 12 d'un même module 8.

Un module 8 est adapté pour recevoir au moins un équipement électronique 2, disposé verticalement entre l'étagère inférieure 10 et l'étagère supérieure 12 dudit module 8.

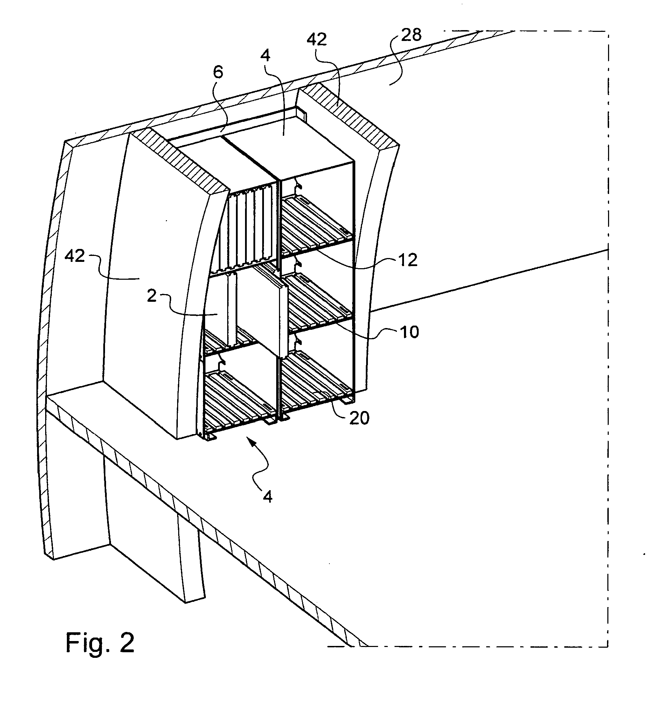

L'équipement électronique 2 comporte un boîtier externe 22 de protection, comme cela est visible notamment sur la figure 2. Le boîtier comporte des nervures 24 formant des moyens de guidage complémentaires adaptés à coopérer avec les moyens formant glissières 20 aménagés sur les étagères du moyen de support 4. Lesdites nervures 24 s'étendent axialement sur une face supérieure et une face inférieure du boîtier 22.

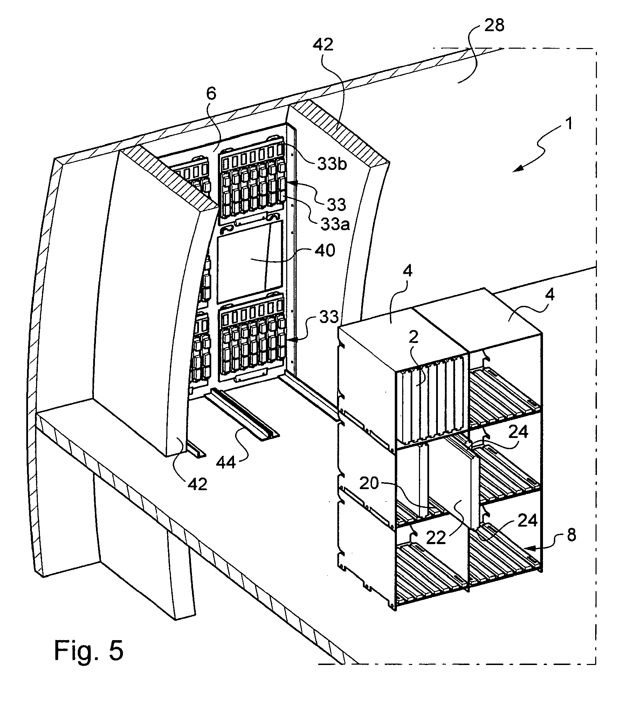

Le boîtier 22 comporte en outre, sur une face, dite arrière, perpendiculaire aux faces supérieure et inférieure, des premiers moyens de connexion 26 visibles sur la figure 5. Lesdits premiers moyens de connexion 26 de chaque équipement électronique 2 disposé dans le moyen de support débouchent sur la face arrière 18 du moyen de support 4.

Au moins une interface de connexion 6 est prévue pour le raccordement du câblage de l'aéronef aux premiers moyens de connexion 26 des équipements électroniques 2 portés par le moyen de support 4.

Comme illustré sur la figure 1, l'interface de connexion 6 est fixée à la structure 28 de l'aéronef.

L'interface de connexion 6 est sensiblement plane. Elle s'étend verticalement, et présente une première face 30 orientée vers l'intérieur de l'aéronef, et une deuxième face opposée (non visible sur les figures) orientée vers la structure 28 de l'aéronef. Le câblage constitué de faisceaux de câbles est rapporté sur ladite deuxième face de l'interface de connexion 6 via des connecteurs montés aux extrémités des faisceaux.

Lorsque les moyens de connexion 26 sont raccordés à l'interface de connexion 6, l'ensemble de connexion est dans un état connecté, avec les équipements électroniques 2 correspondant qui sont reliés au câblage par l'intermédiaire de l'interface de connexion 6. Lorsque les moyens de connexion 26 sont libres, c'est-à-dire qu'ils ne sont pas raccordés à l'interface de connexion, l'ensemble de connexion est dans un état déconnecté.

On observera que l'interface de connexion est fixée à la structure de l'aéronef quel que soit l'état connecté ou déconnecté de l'ensemble de connexion.

L'interface de connexion 6 est fixée directement sur la structure 28 par exemple par l'intermédiaire de sa deuxième face. En variante, des moyens isolants ou des moyens de rigidification sont disposés entre ladite interface et la structure de l'aéronef.

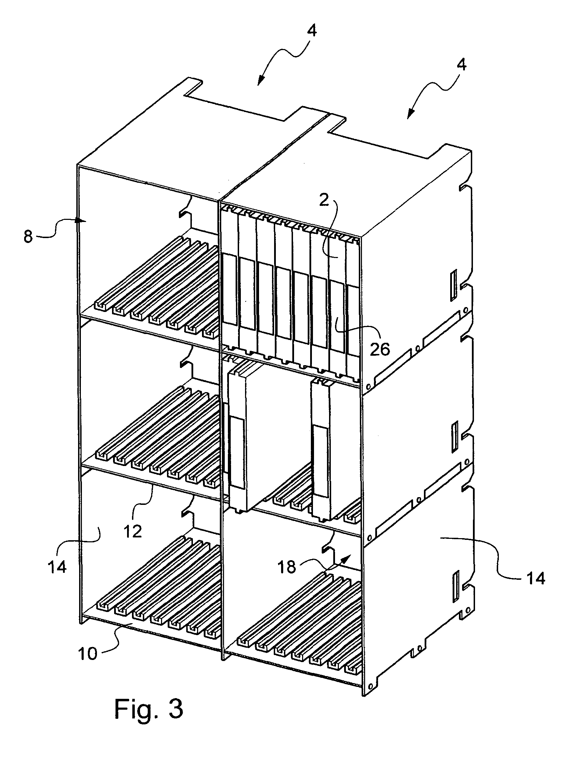

L'interface de connexion 6, telle qu'illustrée sur la figure 1, comporte plusieurs panneaux 32, par exemple six. Chaque panneau 32 comporte sur une face des circuits imprimés (circuits électroniques) et des deuxièmes moyens de connexion 36. On notera qu'il peut s'agir d'un seul circuit imprimé ou de plusieurs cartes. Les panneaux 32 sont orientés de sorte que la face portant les circuits imprimés ainsi que les deuxièmes moyens de connexion 36 est orientée vers l'intérieur de l'aéronef. Lesdits deuxièmes moyens de connexion 36 sont alors aptes à coopérer avec les premiers moyens de connexion 26 des équipements électroniques 2 (Figure 3).

Les panneaux précités peuvent être de deux types.

Dans un premier type, les circuits imprimés 34 recouvrent une partie des panneaux et une partie de la totalité des seconds moyens de connexion (connecteurs) de ces panneaux est montée sur les circuits 34 et est destinée à coopérer avec les premiers moyens 26 pour une connexion indirecte. Cette partie est référencée 36a.

On notera que les connecteurs équipant les faisceaux de câbles sont par exemple fixés en face arrière des circuits imprimés.

Sur une partie de ces panneaux qui n'est pas recouverte de circuits imprimés, l'autre partie 36b des seconds moyens de connexion est directement montée sur la face visible (orientée vers l'intérieur de l'aéronef) du panneau.

Dans cet exemple la partie 36b présente une série d'ouvertures dans lesquelles sont insérés des connecteurs équipant les faisceaux de câbles, ces connecteurs étant ensuite raccordés aux premiers moyens de connexion 26 pour une connexion directe.

On combine ainsi sur un même panneau les avantages d'une connexion indirecte entre le câblage de l'aéronef et les équipements électroniques (via des connecteurs 36a montés sur carte(s) électronique(s)) et d'une connexion directe (connecteurs montés directement sur le panneau).

La connexion indirecte est utilisée lorsque des fonctionnalités sont ajoutées en plus de la simple transmission des signaux via l'interface : gestion de l'alimentation des équipements et de la redondance de cette alimentation, commutation des connexions câblage-équipements, monitoring de fonctions en entrée/sortie des équipements, intégration de protections contre la foudre (filtrage des signaux...)... ou, plus généralement, traitement préalable de certains signaux (protection, mise en forme, ...) avant de les transmettre aux équipements électroniques 2.

La connexion directe est utilisée pour transmettre des signaux aussi rapidement que possible, pour éviter de perturber les signaux, et également pour gérer des liaisons sensibles (fibres optiques) nécessitant des connectiques complexes...

Par ailleurs, les panneaux d'un second type peuvent comporter, d'une part, la partie 36b comme exposé ci-dessus pour une connexion directe câblage aéronef-équipement électroniques et, d'autre part, la partie 36a comportant une ou plusieurs cartes électroniques 34 et des connecteurs pour une connexion aux équipements électroniques. Toutefois, sur ce type de panneaux la face arrière des cartes électroniques n'est pas raccordée aux connecteurs équipant les faisceaux de câbles. Les signaux véhiculés par le câblage de l'aéronef sont ainsi directement transmis via la partie 36b aux équipements électroniques, puis retransmis aux cartes électroniques 34.

Selon une variante non représentée, l'interface comporte des panneaux équipés pour permettre uniquement une connexion directe (seuls les éléments 36b des panneaux de la figure 1 sont présents) et/ou des panneaux équipés pour permettre uniquement une connexion indirecte (les panneaux comportant uniquement une ou plusieurs cartes électroniques 34 équipées des éléments 36a des panneaux de la figure 1) et/ou des panneaux combinant les deux possibilités de connexion directe et indirecte (panneaux du premier type décrits ci-dessus) et/ou des panneaux du second type décrits ci-dessus.

Dans l'exemple des figures 1 à 3, les panneaux sont montés de manière fixe sur l'interface 6.

On va maintenant décrire le fonctionnement de l'ensemble de connexion 1.

Le moyen de support 4 est mobile entre deux positions, une première position dite de retrait, représentée à la figure 1, dans laquelle le moyen de support 4 est éloigné d'une distance donnée de l'interface de connexion 6 et une deuxième position dite active représentée à la figure 2, dans laquelle le moyen de support 4 est positionné au voisinage de l'interface de connexion 6.

La première position de retrait du moyen de support 4 correspond à l'état déconnecté de l'ensemble de connexion 1, avec les premiers moyens de connexion 26 des équipements électroniques 2 qui sont libres de toute connexion, tandis que la deuxième position active du moyen de support 4 correspond à l'état connecté de l'ensemble de connexion 1, avec les premiers moyens de connexion 26 qui sont raccordés à l'interface de connexion 6.

Le moyen de support 4 est translaté vers l'interface de connexion 6 de sa première position vers sa deuxième position. A cet effet, le moyen de support peut comporter des moyens aptes à faciliter son déplacement, comme des roulettes, ou des moyens de préhension pour un appareil de manutention.

Le guidage en translation est facilité par la présence de moyens de guidage disposés au voisinage de l'interface de connexion 6. Comme illustré sur les figures, ces moyens de guidage sont ici des parois verticales 42, solidaires de la structure 28 de l'aéronef et encadrant l'interface de connexion, ainsi que des rails de guidage 44 posés au sol entre les parois 42, devant l'interface.

La connexion d'au moins un équipement électronique 2 au câblage de l'aéronef nécessite alors de placer ledit équipement électronique 2 dans le moyen de support mobile 4, puis d'amener le moyen de support mobile 4 au voisinage de l'interface de connexion 6 fixée sur la structure 28 de l'aéronef et raccordée au câblage. On raccorde alors les premiers moyens de connexion 26 des équipements électroniques 2 portés par le moyen de support avec les deuxièmes moyens de connexion portés par l'interface de connexion 6, que ces deuxièmes moyens soient montés directement ou non sur un panneau. L'ensemble de connexion est alors dans l'état connecté décrit précédemment.

Préalablement à ces étapes de connexion et au déplacement du moyen de support mobile, l'interface de connexion 6 qui est séparée des équipements électroniques 2 est raccordée au câblage de l'aéronef via les connecteurs équipant les extrémités des faisceaux de câbles, puis on fixe ladite interface 6 sur la structure 28 de l'aéronef.

Selon une variante, l'interface de connexion 6 est fixée sur la structure 28 de l'aéronef avant de raccorder ladite interface 6 au câblage de l'aéronef.

On notera que les étapes précitées peuvent être effectuées dans des endroits distincts. Le moyen de support 4 peut être amené à l'intérieur de l'aéronef dans un atelier de montage des équipements, alors que l'interface de connexion 6 a déjà été fixée à la structure 28 dans les usines de fabrication de l'aéronef.

Il convient de noter que dans les modes de réalisation représentés, les équipements électroniques peuvent être montés dans le moyen de support quelle que soit la position dudit moyen de support.

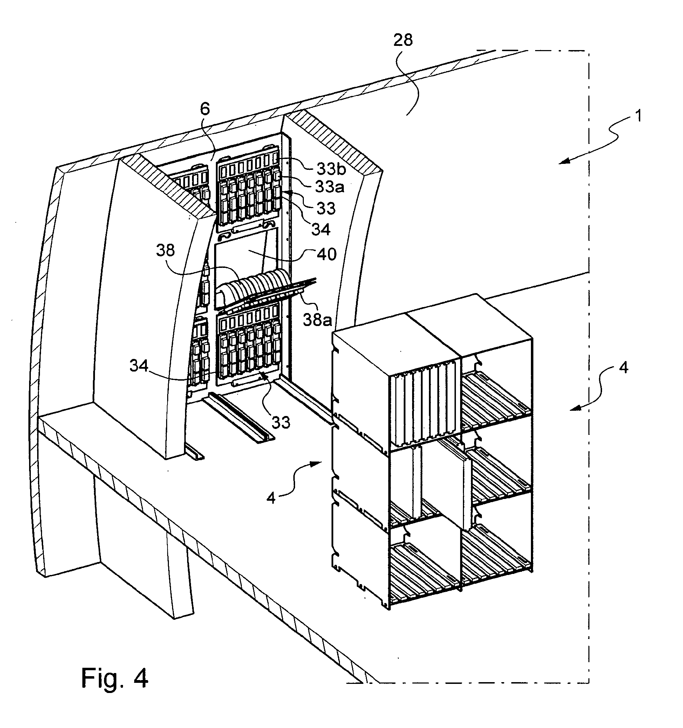

Les figures 4 et 5 illustrent un exemple de réalisation qui permet qu'un équipement électronique 2 soit directement raccordé au câblage de l'aéronef sans l'intermédiaire de l'interface de connexion 6, le panneau mobile 38 de ladite interface 6 étant escamoté.

Dans cet exemple, les panneaux comportent ici des panneaux fixes 33 et un panneau mobile 38 par rapport à l'interface de connexion 6. Le panneau mobile 38 est monté de façon amovible pour prendre une première position identique à celle illustrée sur la figure 1 pour les panneaux fixes, située dans le plan de l'interface de connexion 6, et une deuxième position dite escamotée et illustrée sur la figure 4, dans laquelle un passage 40 est créé à travers l'interface de connexion 6.

Le panneau mobile 38 porte des deuxièmes moyens de connexion 38a tandis que les panneaux fixes 33 de l'interface de connexion 6 portent des deuxièmes moyens de connexion 33a et 33b identiques aux deuxièmes moyens 36a et 36b de la figure 1. Ainsi, les deuxièmes moyens de connexion 38a portés par un panneau mobile 38 sont adaptés à coopérer avec les moyens de connexion d'un premier équipement électronique 2, tandis que les deuxièmes moyens de connexion 33a, 33b portés par un panneau fixe 33 sont adaptés à coopérer simultanément ou non avec les moyens de connexion d'un deuxième équipement électronique 2.

Comme illustré sur la figure 4, le panneau mobile 38 est articulé sur l'interface de connexion, et on escamote ledit panneau mobile 38 en le faisant pivoter autour de son articulation. La position active du moyen de support 4 est alors au plus près possible de l'interface de connexion 6, sans toutefois être au contact du fait de la présence du panneau mobile pivoté 38.

Le panneau mobile articulé permet ainsi à l'utilisateur de passer d'une position située dans le plan de l'interface de connexion à une position escamotée sans enlever le panneau mobile de l'interface de connexion, et donc sans poser un problème de rangement de ce panneau mobile à l'utilisateur.

Le moyen de support 4 est alors amené au voisinage de l'interface de connexion 6 et le câblage de l'aéronef est passé à travers le passage 40 laissé par le panneau mobile 38 escamoté, pour être raccordé directement à l'équipement électronique.

Dans une variante illustrée sur la figure 5, on escamote le panneau mobile 38 en l'enlevant. Ceci présente l'avantage de pouvoir translater le moyen de support 4 contre l'interface de connexion 6 lorsque le panneau mobile 38 est escamoté. On peut ainsi dans le même temps raccorder directement des équipements électroniques au câblage de l'aéronef par le passage 40 créé par l'escamotage de ce panneau mobile 38, et raccorder les autres équipements électroniques par l'intermédiaire de l'interface de connexion 6 et des seconds moyens de connexion 33a, 33b portés par les panneaux fixes.

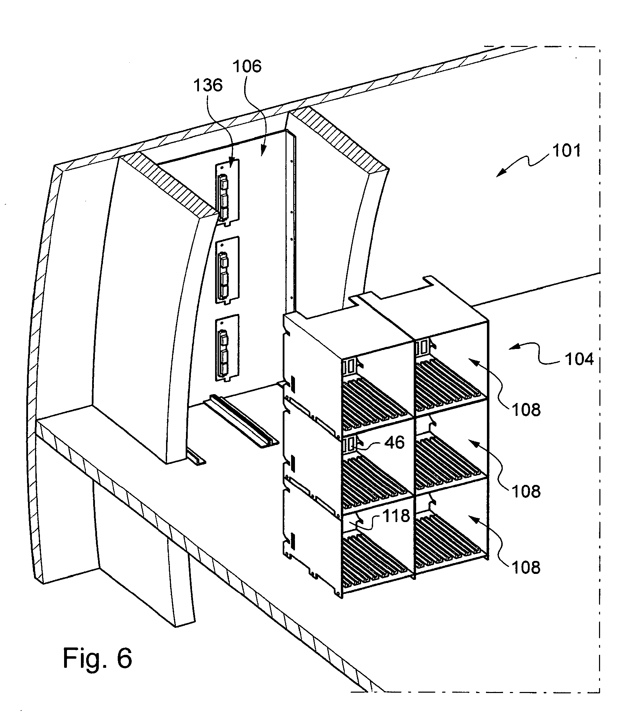

On va maintenant décrire un autre exemple de réalisation d'un ensemble de connexion 101, illustré sur la figure 6, comportant en l'occurrence un moyen de support 104 et une interface de connexion 106.

Le moyen de support 104 est globalement semblable au moyen de support 4, si ce n'est que la face arrière 118 de chaque module 108 que comporte le moyen de support 104 présente une paroi de fermeture 46. Dans chaque module 108, les équipements électroniques se connectent sur ladite paroi de fermeture 46, qui présente sur sa surface externe, orientée vers l'extérieur du moyen de support, un premier moyen de connexion unique non représenté.

L'interface de connexion 106 est sensiblement plane et porte des seconds moyens de connexion 136 adaptés à coopérer avec le moyen de connexion unique en vis-à-vis de chaque module 108 du moyen de support 104.

Cette configuration est par exemple utile pour répartir différentes fonctionnalités entre l'interface de connexion et le moyen de support mobile.

Ainsi, certaines fonctionnalités plus sensibles sont portées par l'interface qui est réalisée par l'avionneur comme par exemple l'intégration d'une fonction de protection contre la foudre (ex : filtrage de signal...) ou l'intégration de connecteurs complexes (ex : optiques...) ...

D'autres fonctionnalités moins sensibles peuvent être déportées sur le moyen de support et être ainsi réalisées par des sous-traitants. Ces fonctionnalités sont par exemple moins complexes à réaliser et donc moins coûteuses.

En outre, le moyen de support s'en trouve simplifié.

Par exemple, le moyen de support est généralement plus simple à fabriquer si les signaux électriques sont déjà traités préalablement (par exemple filtrés dans le but d'une protection contre la foudre) et/ou s'ils sont électriques plutôt qu'optiques...

Conformément au précédent mode de réalisation décrit, l'interface de connexion peut porter des panneaux fixes ou mobiles.

Dans des variantes non représentées du dispositif selon l'invention les différentes caractéristiques qui suivent peuvent être prises isolément ou en combinaison :
- l'interface de connexion comporte un nombre de panneaux différent de six, par exemple un seul ; le moyen de support comporte de façon correspondante un nombre de modules différent de six, par exemple un seul ;
- l'interface de connexion ne comporte que des panneaux mobiles ;
- le moyen de support présente une forme différente de celle décrite, par exemple une forme impliquant une disposition horizontale des modules ; le moyen de support n'est pas mobile mais rapporté contre l'interface de connexion, avec une interface de connexion fixée à la structure de l'aéronef préalablement au montage du moyen de support ; les équipements électroniques sont directement raccordés à l'interface de connexion sans l'intermédiaire d'un moyen de support ;
- le moyen de support comporte une unique face ouverte, avec la face opposée qui est fermée ; les premiers moyens de connexion portés par chaque équipement électronique débouchent sur cette face ouverte, et les équipements électroniques sont insérés dans le moyen de support par cette face ouverte ;
- les moyens de guidage sont différents, par exemple en étant situés selon des orientations différentes ;
- l'interface de connexion solidaire de la structure de l'aéronef n'est pas positionnée contre une paroi latérale de l'aéronef, mais dans la partie centrale de l'aéronef ; et
- le moyen de support intègre un système de refroidissement, autonome ou dépendant du système de refroidissement de l'aéronef.

## Revendications

1. Ensemble de connexion (1 ; 101) comprenant au moins un équipement électronique (2) disposé dans un moyen de support (4), l'équipement électronique comportant des moyens de connexion (26) adaptés à être raccordés à un câblage d'aéronef et une interface de connexion (6 ; 106) disposée entre le câblage de l'aéronef et les moyens de connexion (26) pour assurer la connexion dudit au moins un équipement électronique (2) audit câblage,
ledit ensemble de connexion (1 ; 101) étant adapté à passer d'un état connecté dans lequel les moyens de connexion (26) sont raccordés à l'interface de connexion (6 ; 106) à un état déconnecté dans lequel les moyens de connexion (26) sont libres,
**caractérisé en ce que** :
- ladite interface de connexion (6 ; 106) est fixée à la structure (28) de l'aéronef, que l'ensemble de connexion (1 ; 101) soit dans l'état connecté ou déconnecté,
- le moyen de support (4) est mobile et comporte une face au moins partiellement ouverte orientée vers l'interface de connexion (6 ; 106) et sur laquelle débouchent les moyens de connexion (26) dudit au moins un équipement électronique (2), et
- la connexion dudit au moins un équipement électronique (2) à l'interface de connexion (6 ; 106) se fait par déplacement du moyen de support (4) entre une première position où l'ensemble de connexion (1 ; 101) est dans un état déconnecté et une deuxième position où il est dans un état connecté.

2. Ensemble selon la revendication 1, **caractérisé en ce que** l'interface de connexion (6 ; 106) présente une première face (30) orientée vers l'intérieur de l'aéronef, et une deuxième face orientée vers la structure (28) de l'aéronef, le câblage étant rapporté sur ladite deuxième face de l'interface de connexion (6 ; 106).

3. Ensemble selon la revendication 1 ou 2, **caractérisé en ce que**, les moyens de connexion (26) dudit au moins un équipement électronique (2) étant appelés premiers moyens de connexion, l'interface de connexion (6 ; 106) comporte des seconds moyens de connexion (36 ; 136) adaptés pour coopérer avec les premiers moyens de connexion (26) dudit au moins un équipement électronique (2).

4. Ensemble selon la revendication 3, **caractérisé en ce que** l'interface de connexion (6 ; 106) comporte au moins un panneau qui, d'une part, est relié au câblage de l'aéronef et d'autre part, porte les seconds moyens de connexion (36 ; 136) qui sont aptes à coopérer avec les premiers moyens de connexion (26).

5. Ensemble selon la revendication 4, **caractérisé en ce que** les moyens de connexion sont montés au moins en partie sur un ou plusieurs circuits électroniques fixés au panneau.

6. Ensemble selon l'une des revendications 1 à 5, **caractérisé en ce que** le moyen de support mobile (4 ; 104) comporte au moins une face (16, 18) ouverte, ledit au moins un équipement électronique (2) étant disposé dans le moyen de support (4 ; 104) de sorte que les premiers moyens de connexion (26) portés par ledit au moins un équipement électronique (2) débouchent sur cette face (16, 18) ouverte.

7. Ensemble selon la revendication 6, **caractérisé en ce que** des moyens de guidage (42, 44) sont disposés sur la structure (28) de l'aéronef, pour guider le moyen de support mobile (4 ; 104) lors de son déplacement entre une première et une deuxième position.

8. Aéronef **caractérisé en ce qu'**il comporte au moins un ensemble de connexion (1 ; 101) d'au moins un équipement électronique selon l'une des revendications 1 à 7.

9. Procédé de connexion d'au moins un équipement électronique (2) à un câblage d'un aéronef, dans lequel :
- on insère au moins un équipement électronique (2) dans un moyen de support mobile (4 ; 104), de sorte que des premiers moyens de connexion (26) portés par l'équipement électronique (2) débouchent sur une face (18) au moins partiellement ouverte du moyen de support mobile (4 ; 104) ;
- on amène le moyen de support mobile (4 ; 104) au voisinage d'une interface de connexion (6 ; 106) fixée sur la structure (28) de l'aéronef, la face au moins partiellement ouverte (18) du moyen de support (4 ; 104) étant orientée vers l'interface de connexion (6 ; 106) ; et
- on connecte les premiers moyens de connexion (26) à des seconds moyens de connexion (36 ; 136) portés par l'interface de connexion (6 ; 106) par déplacement du moyen de support (4 ; 104) entre une première position où l'ensemble de connexion (1 ; 101) est dans un état déconnecté et une deuxième position où il est dans un état connecté

## Patentansprüche

1. Anschlussanordnung (1; 101), umfassend wenigstens eine elektronische Einrichtung (2), die in einem Tragmittel (4) angeordnet ist, wobei die elektronische Einrichtung Anschlussmittel (26), die dazu ausgelegt sind, an eine Verkabelung eines Luftfahrzeugs angeschlossen zu werden, sowie eine Anschlussschnittstelle (6; 106) umfasst, die zwischen der Verkabelung des Luftfahrzeugs und den Anschlussmitteln (26) angeordnet ist, um den Anschluss der wenigstens einen elektronischen Einrichtung (2) an die Verkabelung sicherzustellen,
wobei die Anschlussanordnung (1; 101) dazu ausgelegt ist, von einem angeschlossenen Zustand, in dem die Anschlussmittel (26) an die Anschlussschnittstelle (6; 106) angeschlossen sind, in einen getrennten Zustand, in dem die Anschlussmittel (26) frei sind, überzugehen,
**dadurch gekennzeichnet, dass**:
- die Anschlussschnittstelle (6; 106), ob sich die Anschlussanordnung (1; 101) nun in dem angeschlossenen oder getrennten Zustand befindet, an der Struktur (28) des Luftfahrzeugs befestigt ist,
- das Tragmittel (4) beweglich ist und eine wenigstens teilweise offene Seite, die der Anschlussschnittstelle (6; 106) zugewandt ist und an der die Anschlussmittel (26) der wenigstens einen elektronischen Einrichtung (2) ausmünden, umfasst, und
- das Anschließen der wenigstens einen elektronischen Einrichtung (2) an die Anschlussschnittstelle (6; 106) durch Bewegen des Tragmittels (4) zwischen einer ersten Position, in der die Anschlussanordnung (1; 101) sich in einem getrennten Zustand befindet, und einer zweiten Position, in der sie sich in einem angeschlossenen Zustand befindet, erfolgt.

2. Anordnung nach Anspruch 1, **dadurch gekennzeichnet, dass** die Anschlussschnittstelle (6; 106) eine dem Innenraum des Luftfahrzeugs zugewandte erste Seite (30) und eine der Struktur (28) des Luftfahrzeugs zugewandte zweite Seite aufweist, wobei die Verkabelung an die zweite Seite der Anschlussschnittstelle (6; 106) angesetzt ist.

3. Anordnung nach Anspruch 1 oder 2, **dadurch gekennzeichnet, dass**, da die Anschlussmittel (26) der wenigstens einen elektronischen Einrichtung (2) als erste Anschlussmittel bezeichnet werden, die Anschlussschnittstelle (6; 106) zweite Anschlussmittel (36; 136) umfasst, die dazu ausgelegt sind, mit den ersten Anschlussmitteln (26) der wenigstens einen elektronischen Einrichtung (2) zusammenzuwirken.

4. Anordnung nach Anspruch 3, **dadurch gekennzeichnet, dass** die Anschlussschnittstelle (6; 106) wenigstens eine Platine umfasst, die einerseits mit der Verkabelung des Luftfahrzeugs verbunden ist und andererseits die zweiten Anschlussmittel (36; 136), welche geeignet sind, mit den ersten Anschlussmitteln (26) zusammenzuwirken, trägt.

5. Anordnung nach Anspruch 4, **dadurch gekennzeichnet, dass** die Anschlussmittel wenigstens teilweise auf einem oder mehreren an der Platine befestigten elektronischen Schaltkreisen angebracht sind.

6. Anordnung nach einem der Ansprüche 1 bis 5, **dadurch gekennzeichnet, dass** das bewegliche Tragmittel (4; 104) wenigstens eine offene Seite (16, 18) umfasst, wobei die wenigstens eine elektronische Einrichtung (2) in dem Tragmittel (4; 104) angeordnet ist, so dass die von der wenigstens einen elektronischen Einrichtung (2) getragenen ersten Anschlussmittel (26) an dieser offenen Seite (16, 18) ausmünden.

7. Anordnung nach Anspruch 6, **dadurch gekennzeichnet, dass** Führungsmittel (42, 44) an der Struktur (28) des Luftfahrzeugs angeordnet sind, um das bewegliche Tragmittel (4; 104) bei seiner Bewegung zwischen einer ersten und einer zweiten Position zu führen.

8. Luftfahrzeug, **dadurch gekennzeichnet, dass** es wenigstens eine Anordnung zum Anschließen (1; 101) wenigstens einer elektronischen Einrichtung nach einem der Ansprüche 1 bis 7 umfasst.

9. Verfahren zum Anschließen wenigstens einer elektronischen Einrichtung (2) an eine Verkabelung eines Luftfahrzeugs, wobei:
- wenigstens eine elektronische Einrichtung (2) in ein bewegliches Tragmittel (4; 104) eingesetzt wird, so dass von der elektronische Einrichtung (2) getragene erste Anschlussmittel (26) an einer wenigstens teilweise offenen Seite (18) des beweglichen Tragmittels (4; 104) ausmünden;
- das bewegliche Tragmittel (4; 104) in die Nähe einer Anschlussschnittstelle (6; 106), welche an der Struktur (28) des Luftfahrzeugs befestigt ist, gebracht wird, wobei die wenigstens teilweise offene Seite (18) des Tragmittels (4; 104) der Anschlussschnittstelle (6; 106) zugewandt ist, und
- die ersten Anschlussmittel (26) durch Bewegen des Tragmittels (4; 104) zwischen einer ersten Position, in der die Anschlussanordnung (1; 101) sich in einem getrennten Zustand befindet, und einer zweiten Position, in der sie sich in einem angeschlossenen Zustand befindet, mit von der Anschlussschnittstelle (6; 106) getragenen zweiten Anschlussmitteln (36; 136) verbunden werden.

## Claims

1. Assembly for connection (1; 101) comprising at least one item of electronic equipment (2) disposed in a support means (4), the item of electronic equipment comprising connection means (26) adapted for being connected to the wiring of the aircraft, a connection interface (6; 106) being disposed between the wiring of the aircraft and the connection means (26) to provide connection of the said at least one item of electronic equipment (2) to the wiring,
the said connection assembly (1; 101) being adapted for changing over from a connected state in which the connection means (26) are connected to the connection interface (6; 106) to a disconnected state in which the connection means (26) are free,
**characterized in that**:
- the said connection interface (6; 106) is fastened to the structure (28) of the aircraft, whether the connection assembly (1; 101) is in the connected or disconnected state,
- the support means (4) is movable and comprises an at least partially open face turned toward the connection interface (6; 106) and onto which the connection means (26) of the said at least one item of electronic equipment (2) emerge,
- the connection of the said at least one item of electronic equipment (2) to the connection interface (6; 106) is accomplished by moving the support means (4) between a first position where the connection assembly (1; 101) is in a disconnected state and a second position where it is in a connected state.

2. Assembly according to claim 1, **characterized in that** the connection interface (6; 106) has a first face (30) turned toward the interior of the aircraft, and a second face turned toward the structure (28) of the aircraft, the wiring being added onto the said second face of the connection interface (6; 106).

3. Assembly according to claim 1 or 2, **characterized in that**, the connection means (26) of the said at least one item of electronic equipment (2) being called first connection means, the connection interface (6; 106) comprises second connection means (36; 136) adapted for cooperating with the first connection means (26) of the said at least one item of electronic equipment (2).

4. Assembly according to claim 3, **characterized in that** the connection interface (6; 106) comprises at least one panel which, on the one hand, is connected to the wiring of the aircraft and on the other hand, bears the second connection means (36; 136) which are capable of cooperating with the first connection means (26).

5. Assembly according to claim 4, **characterized in that** the connection means are installed at least partially on one or more electronic circuits fastened to the panel.

6. Assembly according to one of claims 1 to 5, **characterized in that** the movable support means (4; 104) comprises at least one open face (16, 18), the said at least one item of electronic equipment (2) being disposed in the support means (4; 104) so that the first connection means (26) borne by the said at least one item of electronic equipment (2) emerge onto this open face (16, 18).

7. Assembly according to claim 6, **characterized in that** guidance means (42, 44) are disposed on the structure (28) of the aircraft, to guide the movable support means (4; 104) during its movement between a first and a second position.

8. Aircraft **characterized in that** it comprises at least one connection assembly (1; 101) for at least one item of electronic equipment according to one of claims 1 to 7.

9. Method for connection of at least one item of electronic equipment (2) to wiring of an aircraft, in which:
- at least one item of electronic equipment (2) is inserted into a movable support means (4; 104), so that first connection means (26) borne by the item of electronic equipment (2) emerge onto an at least partially open face (18) of the movable support means (4; 104);
- the mobile support means (4; 104) is brought close to a connection interface (6; 106) fastened onto the structure (28) of the aircraft, the at least partially open face (18) of the support means (4; 104) being turned toward the connection interface (6; 106); and
- the first connection means (26) are connected to second connection means (36, 136) borne by the connection interface (6; 106), by moving the mobile support means (4 ; 104) between a first position where the connection assembly (1 ; 101) is in a disconnected state and a second position where it is in a connected state.
